(19)

Europäisches
Patentamt
European
Patent Office
Office européen
des brevets

(11) **EP 1 923 896 A1**

(12) **EUROPEAN PATENT APPLICATION**

(43) Date of publication:
**21.05.2008 Bulletin 2008/21**

(51) Int Cl.:
***H01G 9/20*** (2006.01)

(21) Application number: **07101383.3**

(22) Date of filing: **30.01.2007**

(84) Designated Contracting States:
**AT BE BG CH CY CZ DE DK EE ES FI FR GB GR
HU IE IS IT LI LT LU LV MC NL PL PT RO SE SI
SK TR**
Designated Extension States:
**AL BA HR MK RS**

(30) Priority: **17.11.2006 KR 20060113990**

(71) Applicant: **Samsung SDI Co., Ltd.
Suwon-si
Gyeonggi-do (KR)**

(72) Inventors:
 • **Kang, Moon-Sung
  Kiheung-gu, Yongin-si
  Kyunggi-do (KR)**
 • **Lee, Ji-Won
  Kiheung-gu, Yongin-si
  Kyunggi-do (KR)**
 • **Lee, Wha-Sup
  Gyeonggi-do, (KR)**
 • **Ahn, Kwang-Soon
  Kiheung-gu, Yongin-si
  Kyunggi-do (KR)**

 • **Choi, Jae-Man
  Kiheung-gu, Yongin-si
  Kyunggi-do (KR)**
 • **Lee, Jae-Kwan
  Kiheung-gu, Yongin-si
  Kyunggi-do (KR)**
 • **Kwon, Moon-Seok
  Kiheung-gu, Yongin-si
  Kyunggi-do (KR)**
 • **Shin, Byong-Cheol
  Kiheung-gu, Yongin-si
  Kyunggi-do (KR)**
 • **Moon, Soo-Jin
  Kiheung-gu, Yongin-si
  Kyunggi-do (KR)**
 • **Park, Joung-Won
  Kiheung-gu, Yongin-si
  Kyunggi-do (KR)**

(74) Representative: **Hengelhaupt, Jürgen et al
Gulde Hengelhaupt Ziebig & Schneider
Wallstrasse 58/59
10179 Berlin (DE)**

(54) **Electrolyte composition for dye-sensitized solar cell, dye-sensitized solar cell including same, and method of preparing same**

(57) An electrolyte composition for a dye sensitized solar cell according to one embodiment includes a first compound being a polymer or a non-volatile liquid compound having a weight average molecular weight of less than or equal to 500, a second compound being a polymer having a weight average molecular weight of more than or equal to 2000, inorganic nano-particles, and in an additionally embodiment further a redox derivative, a solar cell which includes the electrolyte composition and their manufacturing.

EP 1 923 896 A1

**Description**

**Field of the Invention**

The present disclosure relates to an electrolyte composition for a dye sensitized solar cell, a dye sensitized solar cell including the same, and a method for preparing the same. More particularly, the present disclosure relates to an electrolyte composition for a dye sensitized solar cell that has excellent ion conductivity, and can improve stability and durability of a dye sensitized solar cell, a dye sensitized solar cell including the same, and a method for preparing the same.

**Description of the Related Technology**

Various research attempts have been carried out to develop energy sources that can replace conventional fossil fuels and solve the approaching energy crisis problem. Particularly, extensive research is underway to find ways for using alternative energy sources, such as wind power, atomic power, and solar power, as substitutes for petroleum resources, which are expected to be depleted within several decades. Among the alternative energy sources, solar cells use solar energy that is infinite and environmentally friendly, as opposed to other energy sources. Since 1983 when a Se solar cell was first produced, solar cells have been highlighted, and Si solar cells have recently been drawing attention from researchers.

However, it is difficult to practically use Si solar cells because the production cost is high and there are difficulties in improving cell efficiency. To overcome the problem, researchers are paying attention to a dye sensitized solar cell that can be produced at a low cost.

**SUMMARY OF THE INVENTION**

According the invention there is provided an electrolyte composition for a dye sensitized solar cell having excellent ion conductivity. Furthermore there is provided a dye sensitized solar cell including the electrolyte composition, and a method for preparing the dye sensitized solar cell.

The inventive electrolyte composition for a dye sensitized solar cell comprises: a first compound having a weight average molecular weight of less than or equal to about 500 which is a polymer or a non-volatile non-polymeric liquid compound; a second compound which is a polymer having a weight average molecular weight of more than or equal to about 2000; and inorganic nano-particles.

In the case the first compound is a polymer this first polymer may comprise a liquid-phase polymer. In a preferred variant the first polymer may comprise at least one selected from the group consisting of polyalkyleneoxide, polyacrylonitrile, polyalkylether, polyalkyleneimine, polyalkylenesulfide, a copolymer of two or more of the foregoing, and a mixture of two or more of the foregoing. The first polymer may be in an amount of about 1 to about 95wt% based on the total weight of the composition.

In the case the first compound is a non-volatile non-polymeric liquid compound having a molecular weight of less than or equal to about 500, this non-polymeric compound may comprise one selected from the group consisting of alkylene carbonate, a room temperature molten salt, and a combination thereof. The room temperature molten salt may comprise an ionic liquid compound comprising imidazolium. The non-polymeric compound may be in an amount of about 1 to about 95wt% based on the total weight of the composition.

The second compound which is a polymer may comprise a solid-phase polymer. In a preferred variant the second polymer may comprise at least one selected from the group consisting of polyalkyleneoxide, polyacrylonitrile, polyalkyleneimine, polyalkylenesulfide, polyvinylidenehalide, a copolymer of two or more of the foregoing, and a mixture of two or more of the foregoing. The second polymer may be in an amount of about 1 to about 20wt% based on the total weight of the composition.

The inorganic nano-particles may comprise at least one selected from the group consisting of a carbon-based material, a metal oxide, and a combination thereof. The carbon-based material may comprise at least one selected from the group consisting of graphite, denka black, ketjen black, acetylene black, carbon nanotubes, carbon nanofiber, carbon nanowire, carbon nanoballs, activated carbon, fullerene, and combinations thereof. The metal oxide may comprise an oxide of one selected from the group consisting of Al, Si, Sn, Zr, Ti, W, Zn, In, Ba, Nb, Ta, La, Sr, Y, Ho, Bi, Ce, and combinations thereof. The inorganic nano-particles have preferred an average particle diameter of less than about $1\mu$m. The inorganic nano-particles may be in an amount of about 1 to about 30wt% based on the total weight of the composition.

The composition may further comprise a redox derivative, wherein the redox derivative may be configured to produce an $I/I_3^-$ redox couple. The composition may further comprise a volatile organic solvent selected from the group consisting of acetonitrile, alcohol, tetrahydrofuran, acetone, dimethylsulfoxide, dimethylformamide, methoxyacetonitrile, and a mixture of two or more of the foregoing. The electrolyte composition is preferred in a form of a gel.

Subject-matter of the invention is furthermore a dye sensitized solar cell, comprising the electrolyte composition described above. In a preferred embodiment the solar cell may comprise: a first electrode; and a second electrode substantially opposing the first electrode, wherein at least one layer comprising the electrolyte composition may be interposed between the first and second electrodes. At least one of the first and second electrodes may be substantially transparent.

A preferred solar cell may comprise: a first layer interposed between the first and second electrodes, the first layer comprising the electrolyte composition having a first viscosity; and a second layer interposed between the first layer and the second electrode, the second layer comprising the composition having a second viscosity, the second viscosity being different from the first viscosity. The electrolyte composition has preferred an increasing viscosity gradient from the first electrode toward the second electrode.

Furthermore the invention provides an apparatus comprising the solar cell, wherein the apparatus may be selected from the group consisting of external glass walls of a building or a glass greenhouse.

As already mentioned alternatively an electrolyte composition for a dye sensitized solar cell is provided comprising: a non-volatile non-polymeric liquid compound having a molecular weight of less than or equal to about 500; a polymeric compound having a weight average molecular weight of more than or equal to about 2000; and an inorganic nano-particles.

The non-polymeric compound may comprise one selected from the group consisting of alkylene carbonate, a room temperature molten salt, and a combination thereof. The room temperature molten salt may comprise an ionic liquid compound comprising imidazolium. The non-polymeric compound may be in an amount of about 1 to about 95wt% based on the total weight of the composition.

The polymeric compound may comprise a solid-phase polymer. The polymeric compound may comprise at least one selected from the group consisting of polyalkyleneoxide, polyacrylonitrile, polyalkyleneimine, polyalkylenesulfide, polyvinylidenehalide, a copolymer of two or more of the foregoing, and a mixture of two or more of the foregoing. The polymeric compound may be in an amount of about 1 to about 20wt% based on the total weight of the composition.

The inorganic nano-particles may comprise at least one selected from the group consisting of a carbon-based material, a metal oxide, and a combination thereof. The carbon-based material may comprise at least one selected from the group consisting of graphite, denka black, ketjen black, acetylene black, carbon nanotubes, carbon nanofiber, carbon nanowire, carbon nanoballs, activated carbon, fullerene, and combinations thereof. The metal oxide may comprise an oxide of one selected from the group consisting of Al, Si, Sn, Zr, Ti, W, Zn, In, Ba, Nb, Ta, La, Sr, Y, Ho, Bi, Ce, and combinations thereof. The inorganic nano-particles may have an average particle diameter of less than about $1\mu$ m. The inorganic nano-particles may be in an amount of about 1 to about 30wt% based on the total weight of the composition.

The composition may further comprise a redox derivative, wherein the redox derivative may be configured to produce an $I/I_3^-$ redox couple. The composition may further comprise a volatile organic solvent selected from the group consisting of acetonitrile, alcohol, tetrahydrofuran, acetone, dimethylsulfoxide, dimethylformamide, methoxyacetonitrile, and a mixture of two or more of the foregoing. The composition may be in a form of a gel.

Furthermore a dye sensitized solar cell is provided comprising the composition described above. The solar cell may further comprise: a first electrode; and a second electrode substantially opposing the first electrode, wherein the composition may be interposed between the first and second electrodes. At least one of the first and second electrodes may be substantially transparent.

The solar cell may further comprise: a first layer interposed between the first and second electrodes, the first layer comprising the composition having a first viscosity; and a second layer interposed between the first layer and the second electrode, the second layer comprising the composition having a second viscosity, the second viscosity being different from the first viscosity. The composition may have an increasing viscosity gradient from the first electrode toward the second electrode.

A preferred method of manufacturing the dye sensitized solar cell comprises the following steps: forming a light absorption layer over a first electrode, the light absorption layer comprises a porous membrane; providing at least one of the compositions described above in or on the light absorption layer, thereby forming an electrolyte preferred in gel form; and forming a second electrode over the electrolyte.

In the case that the electrolyte composition comprises further a volatile organic solvent selected from the group consisting of acetonitrile, alcohol, tetrahydrofuran, acetone, dimethylsulfoxide, dimethylformamide, methoxyacetonitrile, and combinations thereof, the method may further comprise vaporizing the volatile organic solvent after providing the composition.

In the case that the solar cell comprises compositions which may comprise increasing the viscosity of the composition from the first electrode toward the second electrode a preferred method of manufacturing is as follows:

Providing a layer with an above composition having a first viscosity; and providing a layer with an above composition having a second viscosity, whereas the second viscosity being different from the first viscosity so that the electrolyte composition shows an increasing viscosity gradient from the first electrode toward the second electrode.

In another embodiment of the invention, a preferred electrolyte composition for a dye sensitized solar cell is provided which includes next to the first polymer or the non-volatile liquid compound having a weight average molecular weight of less than or equal to about 500, the second polymer having a weight average molecular weight of more than or equal to about 2000, and the inorganic nano-particles, a redox derivative.

Subject-matter of the invention is furthermore a dye sensitized solar cell including such a electrolyte composition. According to yet another embodiment, a dye sensitized solar cell is provided. A preferred dye sensitized solar cell includes a first dye sensitized electrode disposed on one side of a first electrode, a light absorption layer disposed on the other side of the first electrode, a second electrode disposed facing the first electrode, and an electrolyte disposed between the first and second electrodes. The light absorption layer includes a porous membrane including preferably semiconductor particles and a dye adsorbed on the porous membrane.

The preferred method of manufacturing such a solar cell includes the following steps: forming a light absorption layer including a porous membrane on which dyes are adsorbed on a first electrode; coating a polymer electrolyte composition (preferably in gel form) including the first polymer or the non-volatile liquid compound having a weight average molecular weight of less than or equal to about 500, a second polymer having a weight average molecular weight of more than or equal to about 2000, the inorganic nano-particles, and the redox derivative, on the light absorption layer to form a polymer electrolyte; and positioning a second electrode on the polymer electrolyte followed by assembling the first and second electrodes. The second electrode comprises at least two through-holes. The method further includes removing extra polymer electrolyte through the through-holes after assembling the first and second electrodes and then sealing the through-holes.

**BRIEF DESCRIPTION OF THE DRAWINGS**

FIG. 1 is a schematic cross-sectional view of a dye sensitized solar cell according to one embodiment.
FIG. 2 illustrates a manufacturing process of a dye sensitized solar cell according to one embodiment.
FIG. 3A is a photograph of electrolyte filled in a solar cell according to Example 1.
FIG. 3B is a photograph of electrolyte filled in a solar cell according to Comparative Example 8.
FIG. 4A is a SEM photograph showing a cross-section of a porous membrane of the solar cell according to Example 1.
FIG. 4B is a SEM photograph showing a cross-section of a porous membrane of the solar cell according to Comparative Example 4.
FIG. 5 is a graph showing the photoelectric current-voltage characteristics of solar cells according to Example 17 and Comparative Examples 6 and 7.
FIG. 6 is a graph showing the incident photon-to-current efficiency (IPCE) of the solar cells according to Example 17 and Comparative Examples 6 and 7.
FIG. 7 is a graph showing the current-potential characteristics of the solar cells according to Example 17 and Comparative Examples 6 and 7.
FIG. 8 is a graph showing the incident photon-to-current efficiency change of solar cells according to Example 10 and Comparative Example 3.
FIG. 9 is a graph showing the efficiency change (decrement) during operations of the solar cells according to Example 10 over 60 days.

**DETAILED DESCRIPTION OF PREFERRED EMBODIMENTS**

An exemplary embodiment will hereinafter be described in detail with reference to the accompanying drawings.
Unlike Si solar cells, the dye sensitized solar cell is an electrochemical solar cell that includes photosensitive dye molecules and a transition metal. The dye molecules absorb visible rays and produce electron-hole pairs. The transition metal oxide transfers the produced electrons. An inventive dye sensitized solar cell uses preferred nano-titanium oxide, i.e., anatase.
The dye sensitized solar cell can be produced at a low cost. Since it can use a transparent electrode, there is an advantage that it can be applied to external glass walls of a building or a glass greenhouse. However, the dye sensitized solar cell has a limitation in application for practical use due to low photoelectric efficiency.
The photoelectric efficiency of a solar cell is in proportion to the quantity of electrons produced from the absorption of solar beams. The quantity of produced electrons can be increased by raising the absorption of solar beams or the dye adsorption efficiency.
Particles of an oxide semiconductor were prepared in a nano-size to increase the dye adsorption efficiency of each unit area.

Such a dye sensitized solar cell may include a photoanode (hereinafter referred to as "a first electrode") including a semiconductor oxide, a light absorption layer including a porous membrane and dye molecules adsorbed on the porous membrane, a counter electrode (hereinafter referred to as "a second electrode") including a platinum catalyst, and an electrolyte including redox ion pairs. The composition of the electrolyte has a large effect on photoelectric efficiency and durability of a solar cell.

A preferred variant of the present invention is the use of a non-volatile ionic liquid electrolyte which exists in a liquid-phase over a wide temperature range. Especially the non-volatile ionic liquid can prevent problems of electrolyte solution degradation as a result of organic solvent volatilization. The use of the non-volatile ionic liquid can exchange the known organic solvents. It is known that the conventional dye sensitized solar cell may be volatilized when the outer temperature of the solar cell increases by sunlight. Therefore, the use of the present electrolyte composition has the advantageous of long-term stability and commercialization of the dye sensitized solar cell. The conductivity between the two electrodes appreciate, photovoltaic characteristics and lifespan of a solar cell are increased.

Especially a gel electrolyte is preferred which overcomes a electrolyte leakage which could occur during cell fabrication, and which could cause damages to the cell. Therefore the solar cell durability is increased and in addition the cell is easy to handle. The preferred gel electrolyte can be obtained by cross-linking or polymerization of polymers using linkable functional groups of monomers or oligomers. In order to transform the liquid electrolyte into such a preferred gel electrolyte, the physical gel electrolyte is preferred. This is advantageous because the problems in that functional groups may remain by side-reaction or non-reaction after cross-linking or polymerization can be avoided. No initiator or a cross-linking agent for cross-linking and polymerization reactions may also remain in the electrolyte which could deteriorate solar cell voltages or current characteristics. Such a preferred physical gel electrolyte can be obtained by using a matrix of polymers. The preferred gel electrolyte may solve the problems of the liquid electrolyte such as volatility or leakage. It may be formed of polymers and may have an irregular structure. This configuration may deteriorate the adhesion to the metal oxide layer. Thus, it may interfere with transmitting electrons generated from the redox pair, deteriorating the electron conductivity. Further, when the size of the molecular chain is more than several tens to several hundred nanometers, it is difficult to transfer it into pores of the porous layer of the light absorption layer. Therefore, it generally has low conductivity of less than $10^{-6}$S/cm.

According to one embodiment, the electrolyte may be obtained by mixing a redox ion pair with a first polymer having a weight average molecular weight of about 500 or less or a non-volatile liquid mono-molecule and a second polymer having a weight average molecular weight of about 2000 or more, and adding inorganic nano-particles to the same to provide a physical gel. The electrolyte can be easily transmitted into the porous layer of the light absorption layer and provide higher ion conductivity and physical strength. It can improve the stability and the durability of a dye sensitized solar cell.

An electrolyte composition for a dye sensitized solar cell according to one embodiment includes a first polymer having a weight average molecular weight of less than or equal to 500, a second polymer having a weight average molecular weight of more than or equal to 2000, inorganic nano-particles, and furthermore a redox derivative. In another embodiment, the composition may include a non-volatile liquid compound having a molecular weight of less than or equal to about 500 in place of the first polymer.

The first polymer or non-volatile liquid compound increases ion conductivity by dissociating redox ion pairs as well as an interface area contacting an electrode. It also acts as a plasticizer to decrease polymer crystallinity.

The first polymer may have a weight average molecular weight of less than or equal to about 500. According to one embodiment, the first polymer may have a weight average molecular weight of less than or equal to about 250. According to another embodiment, the first polymer may have a weight average molecular weight ranging from about 150 to about 200.

The first polymer may be a colorless, transparent, and low-viscosity polymer. According to one embodiment, the first polymer may be present in a liquid-phase. The liquid-phase polymer has higher ion conductivity ($10^{-4}$ to $10^{-3}$ S/cm) than a solid-phase polymer, and may easily permeate into pores of a porous membrane of a light absorption layer resulting in improvement of current density.

The first polymer may be a polymer including a polar ligand such as oxygen, nitrogen, sulfur, and so on for dissociating redox ion pairs. Non-limiting examples of the first polymer may be selected from the group consisting of polyalkyleneoxide, polyacrylonitrile, polyalkylether, polyalkyleneimine, polyalkylenesulfide, copolymers thereof, and combinations thereof. According to one embodiment, the first polymer may be a polymer selected from the group consisting of poly(ethyleneoxide), poly(propyleneoxide), polyacrylonitrile, poly(ethyleneglycol)dimethylether, polyethyleneimine, polyalkylene sulfide, a copolymer thereof, and combinations thereof.

Examples of the non-volatile liquid compound include alkylenecarbonate such as ethylene carbonate, propylene carbonate, and so on, a room-temperature molten salt, and mixtures thereof. The room-temperature molten salt may be an ionic salt compound including imidazolium. The ionic salt exists as a liquid-phase at room temperature.

The first polymer or non-volatile liquid compound may be present in an amount of about 1 to about 95wt% based on the total weight of the polymer gel electrolyte composition. According to another embodiment, the first polymer or non-volatile liquid compound may be present in an amount of about 25 to about 90wt%, optionally about 50 to about 80wt%.

The second polymer serves to dissociate redox ion pairs like the first polymer and improves mechanical properties by electrolyte gelation. The second polymer may have a weight average molecular weight of more than or equal to about 2000. According to one embodiment, the second polymer may have a weight average molecular weight of about 5000 to about 1,000,000. The second polymer may be a solid-phase polymer that can act as a matrix in an electrolyte and improve mechanical strength of an electrolyte.

The second polymer may be a polymer without a polar ligand such as oxygen, nitrogen, sulfur, and so on for dissociating redox ion pairs. Examples of the second polymer may be selected from the group consisting of polyalkyleneoxide, polyacrylonitrile, polyalkyleneimine, polyalkylenesulfide, polyvinylidenehalide, copolymers thereof, and combinations thereof. According to one embodiment, the second polymer may be a polymer selected from the group consisting of poly(ethyleneoxide), poly(propyleneoxide), polyacrylonitrile, polyethyleneimine, polyalkylene sulfide, polyvinylidene fluoride, copolymers thereof, and combinations thereof.

The second polymer may be present in an amount of about 1 to about 20wt% based on the total weight of the polymer electrolyte composition. According to one embodiment, the second polymer may be present in an amount of about 5 to about 15wt%.

The inorganic nano-particles serve to decrease polymer crystallinity, and increase ion conductivity, thereby preventing ion conductivity decrease due to gelation. They also increase photovoltaic current of a solar cell by increasing sunlight scattering.

The inorganic nano-particles may be formed of at least one material selected from the group consisting of carbon-based materials, a metal oxide, and combinations thereof. Examples of the carbon-based materials include graphite, denka black, ketjen black, acetylene black, carbon nanotubes, carbon nanofiber, carbon nanowire, carbon nanoballs, activated carbon, fullerene, and combinations thereof. The metal oxide may be oxide of an element selected from the group consisting of Al, Si, Sn, Zr, Ti, W, Zn, In, Ba, Nb, Ta, La, Sr, Y, Ho, Bi, Ce, and combinations thereof. According to one embodiment, the metal oxide may be $TiO_2$, $SnO_2$, $SiO_2$, $WO_3$, ZnO, $BaTiO_3$, $Nb_2O_5$, $In_2O_3$, $ZrO_2$, $Ta_2O_5$, $La_2O_3$, $SrTiO_3$, $Y_2O_3$, $Ho_2O_3$, $CeO_2$, $Al_2O_3$, or zeolite. According to another embodiment, the metal oxide may be selected from the group consisting of $TiO_2$, $SnO_2$, $SiO_2$, and zeolite. $TiO_2$ has excellent ion adsorption characteristics on a surface of the nano-particle surface.

As the specific surface area of an inorganic nano-particle is larger, more cations are adsorbed on the particle surface and thereby can provide more anion transferring paths. The inorganic nano-particles may have an average particle diameter of less than about 1μm. According to one embodiment, the inorganic nano-particles have an average particle diameter of more than or equal to about 10nm and less than about 1μm. According to another embodiment, the inorganic nano-particles have an average particle diameter of about 10nm to about 100nm, optionally about 20 to about 30nm.

In one embodiment, the inorganic nano-particles may have a white color. In the case that the inorganic nano-particles are white, a light scattering effect can be more improved and thereby re-utilization of light can be improved in a solar cell.

The inorganic nano-particles may be present in an amount of about 1 to about 30wt% based on the total weight of the polymer gel electrolyte. According to one embodiment, the inorganic nano-particles may be present in an amount of about 5 to about 15wt%.

The preferably used redox derivative serves to continuously transfers electrons between the first and second electrodes by a reversible oxidation-reduction reaction in an electrolyte. More specifically, the redox derivative performs an oxidation-reduction reaction, using electrons transferred from an electrode, and transfers the electrons to a dye at a ground energy state, thereby generating a current.

The redox derivative is a material configured to provide a redox couple. Examples of the redox derivative include a metal halide salt such as lithium iodide, sodium iodide, potassium iodide, lithium bromide, sodium bromide, or potassium bromide; and an iodide of a nitrogen-containing heterocyclic compound such as imidazolium salts, pyridinium salts, quaternary ammonium salts, pyrrolidinium salts, pyrazolidium salts, isothiazolidium salts, isoxazolidium salts, and so on.

Examples of the iodide of the nitrogen-containing heterocyclic compound include 1-methyl-3-propyl imidazolium iodide, 1-methyl-3-isopropyl imidazolium iodide, 1-methyl-3-butyl imidazolium iodide, 1-methyl-3-isobutyl imidazolium iodide, 1-methyl-3-s-butylimidazolium iodide, 1-methyl-3-pentyl imidazolium iodide, 1-methyl-2-isopentyl imidazolium iodide, 1-methyl-2-hexyl imidazolium iodide, 1-methyl-3-isohexylimidazolium iodide, 1-methyl-3-ethyl imidazolium iodide, 1,2-dimethyl-3-propylimidazole iodide, pyrrolidinium iodide, and so on.

The redox derivative is configured to provide an $I^-/I_3^-$ redox couple. For example, the $I^-/I_3^-$ redox couple may be prepared by dissolving iodine in an iodide molten salt or iodine or iodide in a molten salt of a compound except iodide.

The polymer gel electrolyte composition according to one embodiment can further include a volatile organic solvent selected from the group consisting of acetonitrile, alcohol, tetrahydrofuran, acetone, dimethylsulfoxide, dimethylformamide, methoxyacetonitrile, and combinations thereof. The volatile organic solvent increases solubility of the redox couple and decreases viscosity increment by a polymer addition. However, the volatile organic solvent may be volatilized during operation of a dye sensitized solar cell, causing electrolyte loss and conductivity decrease. Therefore, in one embodiment, the volatile organic solvent can be volatilized during fabrication of a dye sensitized solar cell.

The volatile organic solvent may be present in an amount of less than or equal to about 30wt% based on the polymer electrolyte gel composition. According to one embodiment, the volatile organic solvent may be present in an amount of about 10 to about 20wt%.

The polymer gel electrolyte composition does not include a polymer polymerization initiator, a cross-linking agent, and so on. It is a physical gel that is formed by the solid-phase second polymer. The polymer gel electrolyte composition easily permeates into the pores of the light absorption layer, and also provides high ion conductivity and mechanical strength.

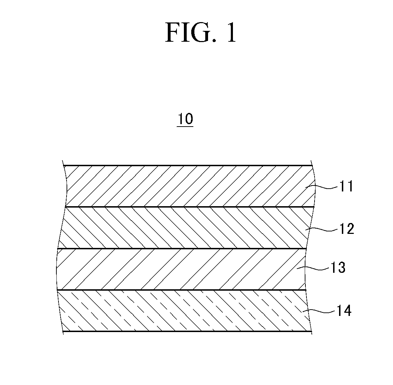

According to another embodiment, a dye sensitized solar cell including the polymer gel electrolyte composition as an electrolyte can be described. FIG. 1 is a cross-sectional view showing a structure of a dye sensitized solar cell in accordance with one embodiment.

Referring to FIG. 1, the dye sensitized solar cell 10 may have a sandwich structure. The structure includes two plate-shaped transparent electrodes: a first electrode 11 and a second electrode 14 facing each other. The light absorption layer 12 is disposed on the surface of the first electrode 11, facing the second electrode 14. A space between the two electrodes 11 and 14 is filled with an electrolyte 13. The light absorption layer 12 may include a porous membrane (not shown) including semiconductor particles and dye molecules adsorbed to the porous membrane.

During operation, solar beams enter the dye sensitized solar cell, and dye molecules in the light absorption layer 12 absorb photons. The dye molecules that have absorbed photons are excited from a ground state, which is called electron transfer, thereby forming electron-hole pairs. The excited electrons are injected into a conduction band on the semiconductor particle interface. The injected electrons are transferred to the first electrode 11 through the interface and then they are transferred to the second electrode 14 through an external circuit. The dye that is oxidized as a result of the electron transfer is reduced by ions of an oxidation-reduction couple in the electrolyte 13. The oxidized ions are involved in a reduction reaction with electrons that have arrived at the interface of the second electrode 14 to achieve charge neutrality.

In one embodiment, the first electrode (working electrode, semiconductor electrode) 11 may include a transparent substrate and a conductive layer disposed on the transparent substrate. The transparent substrate may be formed of any transparent material to transmit external light, such as glass or a plastic material. Non-limiting examples of the plastic material may include polyethyleneterephthalate (PET), polyethylene naphthalate (PEN), polycarbonate (PC), polypropylene (PP), polyimide (PI), triacetyl cellulose (TAC), and polymers thereof. The transparent substrate may be doped with a doping material selected from the group consisting of Ti, In, Ga, and Al.

A conductive layer may be disposed on the transparent substrate. The conductive layer may include a conductive metal oxide selected from the group consisting of indium tin oxide (TO), fluorine tin oxide (FTO), ZnO-($Ga_2O_3$ or $Al_2O_3$), a tin-based oxide, antimony tin oxide (ATO), zinc oxide, and combinations thereof. $SnO_2$ or ITO may be suitable since they have excellent conductivity, transparency, and heat resistance. The conductive layer may include a mono-layered or a multi-layered conductive metal oxide.

The light absorption layer 12 may be formed on the first electrode 11. The light absorption layer 12 may include a porous membrane including semiconductive particles and a photosensitive dye adsorbed on the surface of the porous membrane. The porous membrane has very minute and uniform nano-pores, and includes semiconductor particles having a very minute and uniform average particle size. The semiconductor particles may be of an elementary substance semiconductor, which is represented by silicon, a compound semiconductor, or a perovskite compound.

The semiconductor may be an n-type semiconductor in which electrons of the conduction band become a carrier by being optically excited and provide an anode current. Examples of the compound semiconductor include an oxide including at least one metal selected from the group consisting of Ti, Zr, Sr, Zn, In, Yr, La, V, Mo, W, Sn, Nb, Mg, Al, Y, Sc, Sm, Ga, In, and TiSr. According to one embodiment, the compound semiconductor may be $TiO_2$, $SnO_2$, ZnO, $WO_3$, $Nb_2O_5$, $TiSrO_3$, or mixtures thereof. According to another embodiment, the compound semiconductor may be anatase $TiO_2$. The semiconductor is not limited to the above-mentioned materials, and the above-mentioned materials may be used individually or in combination. The semiconductor particles may have a large surface area to allow the dye adsorbed onto the surface of the semiconductor particles to absorb much light.

The porous membrane may be fabricated in accordance with any conventional method of fabricating a porous membrane. According to one embodiment, it may be fabricated according to a mechanical necking treatment in which the membrane density of the porous membrane is controlled by suitably adjusting treatment conditions.

The surface of the porous membrane adsorbs the dye that absorbs external light and produces excited electrons. The dye may be a metal composite including at least one selected from the group consisting of aluminum (Al), platinum (Pt), palladium (Pd), europium (Eu), lead (Pb), iridium (Ir), ruthenium (Ru), and the like. Since the ruthenium belongs to a platinum-based element and can form many organic metal composites, the ruthenium can be used as a dye. An organic dye such as coumarin, porphyrin, xanthene, riboflavin, triphenyl methane, and so on can be also used.

In the above description, the light absorption layer 12 has a two-layered structure composed of the porous membrane including semiconductive particles and the dye adsorbed on the porous membrane, but it may have a mono-layered structure by the solvent washing process further included after obtaining the light absorption layer. In one embodiment, the light absorption layer 12 may have a thickness of about 15μm or less. According to another embodiment, the thickness ranges from about 1 to about 15μm.

A second electrode (counter electrode) 14 is formed to substantially oppose the first electrode 11 with the light absorption layer 12 interposed therebetween. The second electrode 14 may include a transparent substrate and a transparent electrode facing the first electrode 11, and a catalyst electrode (not shown) formed on the transparent substrate.

The transparent substrate may be formed of a glass or a plastic material as the first electrode. Examples of the plastic include polyethylene terephthalate, polyethylene naphthalate, polycarbonate, polypropylene, polyimide, triacetylcellulose, and so on.

The transparent electrode is disposed on the transparent substrate. The transparent electrode may be formed of a transparent material such as indium tin oxide, fluorine tin oxide, antimony tin oxide, zinc oxide, tin oxide, $ZnO-Ga_2O_3$, $ZnO-Al_2O_3$, and so on. The transparent electrode may include a mono-layered membrane or a multi-layered membrane.

The catalyst electrode is disposed on the transparent electrode. The catalyst electrode serves to activate a redox couple, and includes a conductive material selected from the group consisting of platinum (Pt), gold (Au), ruthenium (Ru), palladium (Pd), rhodium (Rh), iridium (Ir), osmium (Os), carbon (C), $WO_3$, $TiO_2$, and a conductive polymer.

In one embodiment, the catalyst electrode may be porous to increase the surface area so that the catalyst effect is improved. For example, Pt or Au may have a black state (herein, "black state" is referred to as the state in which nothing is supported on the supported body), and carbon may have a porous state. Particularly, the platinum black state may be obtained by a sputtering method, a chloroplatinic acid method, and so on. Further, porous carbon may be obtained by sintering carbon particles or firing organic polymers.

The second electrode 14 includes a through-hole (not shown) penetrating the second electrode. The through-hole allows an extra electrolyte 13 to exit from the solar cell when the first electrode 11 is combined with the second electrode 14. This configuration permits filling the electrolyte without producing pores or air bubbles inside the solar cell. In another embodiment, more than two through-holes may be formed in the second electrode 14 in order to guide the extra electrolyte to the outside. According to another embodiment, more than three through-holes are formed. After the first electrode 11 is combined with the second electrode 14, the hole is sealed with an adhesive material and a cover glass.

As described above, the electrolyte 13 is interposed between the first electrode 11 and the second electrode 14. In the embodiment described above, the electrolyte 13 may be substantially uniformly dispersed inside the porous membrane of the light absorption layer 12.

The electrolyte 13 may include the same polymer gel electrolyte composition as mentioned above. The electrolyte 13 may be a mono-layer of the polymer gel electrolyte having the same viscosity, or a multi-layer thereof having an increasing viscosity from the first electrode 11 toward the second electrode 14.

According to another embodiment, the electrolyte in the porous membrane of the light absorption layer 12 has a lower viscosity than that of the electrolyte interposed between the porous membrane and the second electrode 14. This configuration facilitates transmitting the electrolyte into pores of the porous membrane.

According to yet another embodiment, the viscosity of the electrolyte in the porous membrane may be about 10 to about 100 times lower than that of the electrolyte interposed between the porous membrane and the second electrode 14.

The dye sensitized solar cell 10 may be fabricated using a method including: providing a light absorption layer 12 on a first electrode 11. The light absorption layer 12 can include a porous membrane with a dye adsorbed therein. The method further includes coating the light absorption layer 12 with a polymer gel electrolyte composition. The composition includes a first polymer having a weight average molecular weight of about 500 or less or a non-volatile liquid single molecule, a second polymer having a weight average molecular weight of about 2000 or more, inorganic nanoparticles, and a redox derivative to provide a polymer gel electrolyte 13. The method also includes placing a second electrode 14 on the polymer gel electrolyte so as to face the first electrode 11. It will be appreciated that various methods can be adapted for fabricating a solar cell having the aforementioned structure.

In another embodiment, the polymer gel electrolyte may be provided while generating a viscosity gradient between the first and second electrodes. For example, a lower viscosity composition may be provided first, and then a higher viscosity composition may be provided sequentially, or vice versa. This configuration facilitates transmitting the lower viscous polymer gel electrolyte composition into pores of the porous membrane and to provide a higher viscous polymer gel electrolyte composition on the porous membrane with excellent mechanical strength.

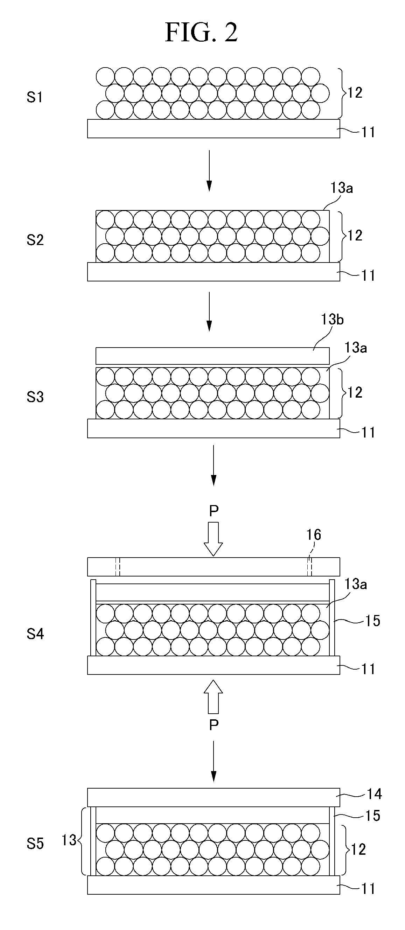

FIG. 2 shows a manufacturing process of the dye sensitized solar cell according to another embodiment, including different viscosity electrolytes. As shown in FIG. 2, a light absorption layer 12 is formed on a first electrode (S1). The first electrode 11 may be the same as mentioned above, and may be fabricated in accordance with any suitable manufacturing method. For example, the first electrode 11 may be obtained by forming a conductive layer including a conductive material on a transparent substrate in accordance with an electroplating or a sputtering process, an electron beam depositing process, and so on.

A porous membrane is formed on the first electrode 11, and a dye molecule is adsorbed in the porous membrane to provide a light absorption layer 12. The porous membrane may be obtained by dispersing the semiconductor particles into a solvent such as alcohol, water, and so on to provide a composition for a porous membrane; coating the composition on the first electrode in accordance with any suitable coating process; and heating or mechanically necking the same.

Subsequently, the porous membrane is sprayed, coated, or immersed with a dispersion solution including a dye to adsorb the dye in the porous membrane. The dye can be adsorbed on the surface of the semiconductive particles in the porous membrane by immersing the porous membrane into a dispersion solution containing the dye for about 12 hours. Herein, the dye may be the same as mentioned above. The solvent is not limited, but may include acetonitrile, dichloromethane, an alcohol-based solvent, and so on. Further, the dispersion solution including the dye may further include various organic colorants to improve the absorption of long wavelength visible light. After forming the dye layer, it is washed with a solvent to provide a mono-layer of a light absorption layer 12.

The first polymer gel electrolyte composition having a lower viscosity is coated on the obtained light absorption layer 12 to provide a first polymer gel electrolyte 13a (S2). The first polymer gel electrolyte composition may be the same as mentioned above. The first polymer gel electrolyte 13a may have a lower viscosity such as about 10cP to about 50cP in order to facilitate transmitting the same into pores of the porous membrane. According to another embodiment, the viscosity may range from about 10cP to about 30cP. Such range of the viscosity of the first polymer gel electrolyte may be suitably adjusted depending upon amounts of the first polymer or the non-volatile organic solvent.

The first polymer gel electrolyte composition can be coated using a method selected from the group consisting of screen printing, spray coating, doctor blade coating, gravure coating, dip coating, silk screening, painting, slot die coating, spin coating, and combinations thereof. The coating method can be selected depending on the composition viscosity. According to one embodiment, doctor blade coating may be used since the composition can be coated in a uniform thickness on a porous membrane.

After the first polymer gel electrolyte 13a is formed, a higher viscosity polymer gel electrolyte composition is coated to provide a second polymer gel electrolyte 13b (S3). The polymer gel electrolyte composition may be the same as mentioned above. However, according to another embodiment, the second polymer gel electrolyte 13b may have a viscosity ranging from about 100cP to about 5000cP in order to provide excellent mechanical strength. According to another embodiment, the viscosity ranges from about 500cP to about 3000cP. Such viscosity control of the second polymer gel electrolyte may be suitably adjusted depending upon amounts of the first polymer and the second polymer or the non-volatile organic solvent. The higher viscosity polymer gel electrolyte composition may be coated in accordance with the above-mentioned method.

After coating the first or the second polymer gel electrolyte composition, it may further include volatilizing volatile organic solvents included in the first or the second polymer gel electrolyte. The volatilizing process is carried out by spontaneous evaporation or vacuum drying. Thereby, air bubble or pore formation may be prevented from increasing the contact interface between the polymer gel electrolyte and the second electrode.

In addition, the second electrode 14 is prepared and disposed on the second polymer gel electrolyte 13b. Then, it is combined with the first electrolyte 11 (S4) to provide a dye sensitized solar cell (S5). The second electrode 14 may include a transparent substrate, a transparent electrode, and a catalyst electrode as mentioned above, and may be fabricated in accordance with any conventional method.

The first electrode 11 may be combined with the second electrode 14 by any suitable method. For example, the first electrode 11 may be combined with the second electrode 14 by using an adhesive material. The adhesive material 15 may include a thermoplastic polymer film such as one of the trade name Surlyn (available from E. I. du Pont de Nemours and Company). The thermoplastic polymer film is disposed between two electrodes and hot-pressed, which seals them. The adhesive material may further include epoxy resins or an ultraviolet ray (UV) hardening agent. Herein, it is hardened after carrying out the heat treatment or UV treatment.

When the first electrode 11 and the second electrode 14 are hot-pressed, the extra electrolyte 13 overflows through the through-hole 16 of the second electrode 14. Thereby, the electrolyte can be substantially uniformly filled without generating pores inside the solar cell by guiding the extra electrolyte to the outside through the through-hole.

The dye sensitized solar cell fabricated by the above mentioned process includes a polymer gel electrolyte, and thus it can improve the cell stability and durability. The following examples illustrate the present disclosure in more detail. However, it is understood that the present disclosure is not limited by these examples.

Example 1

1.20M 1-propyl-3-methylimidazolium iodide and 0.12M iodine were dissolved in a solvent of poly(ethyleneglycol) dimethylether (PEGDME, weight average molecular weight: 250g/mol) to prepare a mixed solution. 10wt% of polyethylene oxide (weight average molecular weight 1,000,000 g/mol) was added to the mixed solution and then agitated. Next, 10wt% of titanium oxide nano-particles (P-25, average particle diameter: 30nm, available from Degussa Corp., Düsseldorf, Germany) were added to the solution and dispersed by agitating and ultra-sonication grinding to prepare a polymer gel electrolyte composition having a viscosity of 1800cP.

30wt% of $TiO_2$ semiconductor particles having an average particle diameter of 20nm were dispersed in 100ml of acetylacetone to prepare a composition for a porous membrane. The composition was coated using a doctor blade at a rate of 5mm/sec on a transparent glass substrate having a substrate resistance of 10Ω/□ on which indium tin oxide (indium doped tin oxide) was coated. Drying and pressing were performed to form a porous membrane including $TiO_2$. The porous membrane had a thickness of 0.035mm.

The first electrode on which the porous membrane was formed was dipped in a 0.3mM ruthenium (4,4-dicarboxyl-2,2'-bipyridine)$_2$(NCS)$_2$ solution for 24 hours to adsorb the dyes on the porous membrane. The porous membrane on which the dyes were adsorbed was washed with ethanol.

The polymer gel electrolyte composition was coated on the first electrode including the porous membrane thereon to form an electrolyte layer. Volatile organic solvents in the polymer gel electrolyte composition were volatilized by drying under vacuum.

Transparent glass substrate having a substrate resistance of 10Ω/□ on which indium tin oxide was coated was deposited with platinum by sputtering to form a catalyst electrode with a surface resistance of 0.5Ω. Thereby, a second electrode was fabricated. Through-holes penetrating the second electrode were formed by a drill bit having a diameter of 0.75mm.

The electrolyte on the first electrode was arranged to face the second electrode and then a 60μm-thick thermoplastic polymer film was positioned between the transparent substrates of the first and second electrodes. The first and second electrodes were subjected to hot-pressing at 80°C for 9 seconds to assembly the first and second electrodes.

Extra electrolyte was removed through the through-holes of the second electrode and then the through-holes of the second electrode were sealed to fabricate a dye sensitized solar cell.

Example 2

The dye sensitized solar cell was fabricated according to the same method as in Example 1, except that poly (ethyleneglycol)dimethylether having a weight average molecular weight of 500g/mol was used to prepare a polymer gel electrolyte composition having a viscosity of 1900cP.

Example 3

The dye sensitized solar cell was fabricated according to the same method as in Example 1, except that ethylenecarbonate (molecular weight: 88.1 g/mol) non-volatile liquid compound was used to prepare a polymer gel electrolyte composition having a viscosity of 1700cP (at 25°C) instead of poly(ethyleneglycol)dimethylether.

Example 4

The dye sensitized solar cell was fabricated according to the same method as in Example 1, except that poly (ethyleneglycol)dimethylether having a weight average molecular weight of 500g/mol and carbon nanotubes (average particle diameter: 30nm) instead of titanium oxide nano-particles were used to prepare a polymer gel electrolyte composition having a viscosity of 1800cP.

Example 5

The dye sensitized solar cell was fabricated according to the same method as in Example 1, except that poly (ethyleneglycol)dimethylether having a weight average molecular weight of 500g/mol and indium tin oxide (average particle diameter: 30nm) were used to prepare a polymer gel electrolyte composition having a viscosity of 1800cP.

Example 6

The dye sensitized solar cell was fabricated according to the same method as in Example 1, except that poly (ethyleneglycol)dimethylether having a weight average molecular weight of 500g/mol and titanium oxide nano-particles (JA-01 available from Tayca Corp., Japan, average particle diameter: 180nm) were used to prepare a polymer gel electrolyte composition having a viscosity of 1800cP.

Example 7

The dye sensitized solar cell was fabricated according to the same method as in Example 1, except that poly (ethyleneglycol)dimethylether having a weight average molecular weight of 500g/mol and titanium oxide nano-particles (synthesized particle, average particle diameter: 10nm) were used to prepare a polymer gel electrolyte composition having a viscosity of 1900cP.

Example 8

The dye sensitized solar cell was fabricated according to the same method as in Example 1, except that poly (ethyleneglycol)dimethylether having a weight average molecular weight of 500g/mol and titanium oxide nano-particles (synthesized particle, average particle diameter: 1 00nm) were used to prepare a polymer gel electrolyte composition having a viscosity of 1900cP.

Example 9

The dye sensitized solar cell was fabricated according to the same method as in Example 1, except that poly (ethyleneglycol)dimethylether having a weight average molecular weight of 500g/mol and titanium oxide nano-particles (synthesized particle, average particle diameter: $1\mu$m) were used to prepare a polymer gel electrolyte composition having a viscosity of 1600cP.

Example 10

1.20M 1-propyl-3-methylimidazolium iodide and 0.12M iodine ($I_2$) were dissolved in a solvent of poly(ethyleneglycol)dimethylether (PEGDME, weight average molecular weight 250g/mol) to prepare a mixed solution. 10wt% of polyethylene oxide (weight average molecular weight 1,000,000 g/mol) was added to the mixed solution and then agitated. 10wt% of titanium oxide nano-particles (P-25, average particle diameter: 30nm, available from Degussa Corp.) and 20wt% of acetonitrile were added to the solution and dispersed by agitating and ultra-sonication grinding to prepare a polymer gel electrolyte composition having a viscosity of 1000cP. Using the polymer gel electrolyte composition, the dye sensitized solar cell was fabricated according to the same method as in Example 1.

Example 11

The dye sensitized solar cell was fabricated according to the same method as in Example 10, except that the titanium oxide nano-particles were used in an amount of 1wt% to prepare a polymer gel electrolyte composition having a viscosity of 1200cP.

Example 12

The dye sensitized solar cell was fabricated according to the same method as in Example 10, except that the titanium oxide nano-particles were used in an amount of 5wt% to prepare a polymer gel electrolyte composition having a viscosity of 1100cP.

Example 13

The dye sensitized solar cell was fabricated according to the same method as in Example 10, except that the titanium oxide nano-particles were used in an amount of 20wt% to prepare a polymer gel electrolyte composition having a viscosity of 920cP.

Example 14

The dye sensitized solar cell was fabricated according to the same method as in Example 10, except that the titanium oxide nano-particles were used in an amount of 30wt% to prepare a polymer gel electrolyte composition having a viscosity of 850cP.

Example 15

The dye sensitized solar cell was fabricated according to the same method as in Example 10, except that the titanium oxide nano-particles were used in an amount of 15wt% to prepare a polymer gel electrolyte composition having a viscosity of 1000cP.

Example 16

The dye sensitized solar cell was fabricated according to the same method as in Example 10, except that the titanium oxide nano-particles were used in an amount of 40wt% to prepare a polymer gel electrolyte composition having a viscosity of 800cP.

Example 17

The dye sensitized solar cell was fabricated according to the same method as in Example 1, except that poly (ethyleneglycol)dimethylether having a weight average molecular weight of 400g/mol was used to prepare a polymer gel electrolyte composition having a viscosity of 2000cP.

Example 18

1.20M 1-propyl-3-methylimidazolium iodide and 0.12M iodine were dissolved in a solvent of poly(ethyleneglycol) dimethylether (PEGDME, weight average molecular weight: 250g/mol) to prepare a mixed solution. 10wt% of polyethylene oxide (weight average molecular weight 1,000,000 g/mol) was added to the mixed solution and then agitated. 10wt% of titanium oxide nano-particles (P-25, average particle diameter: 30nm, available from Degussa Corp.) and 20wt% of acetonitrile were added to the solution and dispersed by agitating and ultra-sonication grinding to prepare a first polymer gel electrolyte composition having a viscosity of 25 to 30cP.

A second polymer gel electrolyte composition was prepared according to the same method as the first polymer gel electrolyte composition, except that 5wt% of acetonitrile was used.

30wt% of $TiO_2$ semiconductor particles having an average particle diameter of 20nm were dispersed in 100 ml of acetylacetone to prepare a composition for a porous membrane. The composition was coated using a doctor blade at a rate of 5mm/sec on a transparent glass substrate having a substrate resistance of 10Ω/□ on which indium tin oxide (indium doped tin oxide) was coated. Drying and pressing were performed to form a porous membrane including $TiO_2$. The porous membrane had a thickness of 0.035mm.

The first electrode on which the porous membrane was formed was dipped in a 0.3mM ruthenium (4,4-dicarboxyl-2,2'-bipyridine)$_2$(NCS)$_2$ solution for 24 hours to adsorb the dyes on the porous membrane. The porous membrane on which the dyes were adsorbed was washed with ethanol.

The first polymer gel electrolyte composition was coated on the first electrode including the porous membrane thereon to form a first electrolyte layer. Volatile organic solvents in the first polymer gel electrolyte composition were volatilized by drying under vacuum.

The second polymer gel electrolyte composition was coated on the first electrode including the first electrolyte layer thereon to form a second electrolyte layer.

A transparent glass substrate having a substrate resistance of 10Ω/□ on which indium tin oxide was coated was deposited with platinum by sputtering to form a catalyst electrode with a surface resistance of 0.5Ω. Thereby, a second electrode was fabricated. Through-holes penetrating the second electrode were formed by drilling with a bit having a diameter of 0.75mm.

The electrolyte on the first electrode was arranged to face the second electrode and then a 60μm-thick thermoplastic polymer film was positioned between the transparent substrates of the first and second electrodes. The first and second electrodes were subjected to hot-pressing at 80°C for 9 seconds to assemble the first and second electrodes.

Extra electrolyte was removed through the through-holes of the second electrode and then the through-holes of the second electrode were sealed to fabricate a dye sensitized solar cell.

Comparative Example 1

1.20M 1-propyl-3-methylimidazoliumiodide and 0.12M iodine were dissolved in a solvent of poly(ethyleneglycol) dimethylether (PEGDME, weight average molecular weight 250g/mol) to prepare a mixed solution.

30wt% of $TiO_2$ semiconductor particles having an average particle diameter of 20nm were dispersed in 100 ml of acetylacetone to prepare a composition for a porous membrane. The composition was coated using a doctor blade at a rate of 5mm/sec on a transparent glass substrate having a substrate resistance of 10Ω/□ on which indium tin oxide (indium doped tin oxide) was coated. Drying and pressing were performed to form a porous membrane including $TiO_2$. The porous membrane had a thickness of 0.035mm.

The first electrode on which the porous membrane was formed was dipped in a 0.3mM ruthenium (4,4-dicarboxyl-

2,2'-bipyridine)$_2$(NCS)$_2$ solution for 24 hours to adsorb the dyes on the porous membrane. The porous membrane on which the dyes were adsorbed was washed with ethanol to prepare a light absorption layer.

A transparent glass substrate having a substrate resistance of 10Ω/□ on which indium tin oxide was coated was deposited with platinum by sputtering to form a catalyst electrode with a surface resistance of 0.5Ω. Thereby, a second electrode was fabricated. Through-holes penetrating the second electrode were formed by drilling with a drill bit having a diameter or 0.75mm.

The light absorption layer on the first electrode was arranged to face the second electrode and then a 60μm-thick thermoplastic polymer film was positioned between the transparent substrates of the first and second electrodes. The first and second electrodes were subjected to hot-pressing at 80°C for 9 seconds to assembly the first and second electrodes. The electrolyte prepared as above was injected into the through-holes of the second electrode. The through-holes were sealed with a thermoplastic polymer film and a cover glass to fabricate a dye sensitized solar cell.

Comparative Example 2

1.20M 1-propyl-3-methylimidazolium iodide and 0.12M iodine were dissolved in a solvent of poly(ethyleneglycol) dimethylether (PEGDME, weight average molecular weight: 250g/mol) to prepare a mixed solution. 10wt% of silica nano-particles (average particle diameter: 30nm) (fumed silica, available from Aldrich, St. Louis, MO) were added to the mixed solution and then dispersed by agitating and ultra-sonication grinding to prepare a polymer gel electrolyte composition having a viscosity of 3000cP. Using the polymer gel electrolyte composition, the dye sensitized solar cell was fabricated according to the same method as in Comparative Example 1.

Comparative Example 3

1.20M 1-propyl-3-methylimidazolium iodide and 0.12M iodine were dissolved in a solvent of poly(ethyleneglycol) dimethylether (PEGDME, weight average molecular weight: 250g/mol) to prepare a mixed solution. 10wt% of polyethylene oxide (weight average molecular weight 1,000,000 g/mol) was added to the mixed solution and then mixed by agitating and ultra-sonication grinding to prepare a polymer gel electrolyte composition having a viscosity of 2000cP. Using the polymer gel electrolyte composition, the dye sensitized solar cell was fabricated according to the same method as in Example 1.

Comparative Example 4

The dye sensitized solar cell was fabricated according to the same method as in Example 1, except that poly (ethyleneglycol)dimethylether having a weight average molecular weight of 750g/mol was used.

Comparative Example 5

The dye sensitized solar cell was fabricated according to the same method as in Example 1, except that poly (ethyleneglycol)dimethylether having a weight average molecular weight of 1000g/mol was used.

Comparative Example 6

The dye sensitized solar cell was fabricated according to the same method as in Comparative Example 1, except that 1.20M 1-propyl-3-methylimidazoliumiodide and 0.12M iodine were dissolved in a solvent of poly(ethyleneglycol)dimethylether (PEGDME, weight average molecular weight 400g/mol) to prepare a mixed solution, which was used as an electrolyte.

Comparative Example 7

1.20M 1-propyl-3-methylimidazolium iodide and 0.12M iodine were dissolved in a solvent of poly(ethyleneglycol) dimethylether (PEGDME, weight average molecular weight: 400g/mol) to prepare a mixed solution. 10wt% of polyethylene oxide (weight average molecular weight 1,000,000 g/mol) was added to the mixed solution and then agitated to prepare a polymer gel electrolyte composition having a viscosity of 2200cP. Using the polymer gel electrolyte composition, the dye sensitized solar cell was fabricated according to the same method as in Example 1.

Comparative Example 8

The polymer gel electrolyte composition was prepared according to the same method as in Example 1, except that poly(ethyleneglycol)dimethylether having a weight average molecular weight of 750g/mol was used.

30wt% of $TiO_2$ semiconductor particles having an average particle diameter of 20nm were dispersed in 100 ml of acetylacetone to prepare a composition for a porous membrane. The composition was coated using a doctor blade at a rate of 5mm/sec on a transparent glass substrate having a substrate resistance of $10\Omega/\square$ on which indium tin oxide (indium doped tin oxide) was coated. Drying and pressing were performed to form a porous membrane including $TiO_2$. The porous membrane had a thickness of 0.035mm.

The first electrode on which the porous membrane was formed was dipped in a 0.3mM ruthenium (4,4-dicarboxyl-2,2'-bipyridine)$_2$(NCS)$_2$ solution for 24 hours to adsorb the dyes on the porous membrane. The porous membrane on which the dyes were adsorbed was washed with ethanol.

The polymer gel electrolyte composition was coated on the first electrode including the porous membrane thereon to form an electrolyte layer.

A transparent glass substrate having a substrate resistance of $10\Omega/\square$ on which indium tin oxide was coated was deposited with platinum by sputtering to form catalyst electrode with a surface resistance of $0.5\Omega$. Thereby, a second electrode was fabricated.

The electrolyte on the first electrode was arranged to face the second electrode and then a $60\mu m$-thick thermoplastic polymer film was positioned between the transparent substrates of the first and second electrodes. The first and second electrodes were subjected to hot-pressing at 80°C for 9 seconds to assembly the first and second electrodes.

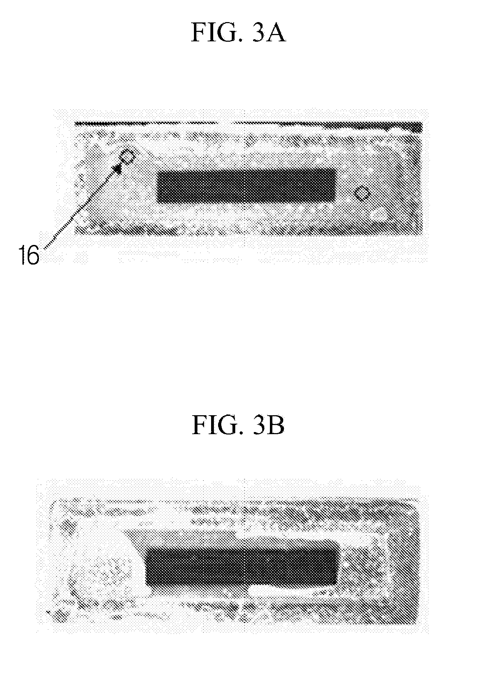

The dye sensitized solar cells according to Example 1 and Comparative Example 8 were evaluated in terms of electrolyte filling. The evaluation results are shown in FIGS. 3A and 3B.

FIG. 3A is a photograph of electrolyte filling in the solar cell according to Example 1, and FIG. 3B is a photograph of electrolyte filling in the solar cell according to Comparative Example 8. The reference numeral 16 denotes a through-hole of the second electrode.

As shown in FIGS. 3A and 3B, in the solar cell according to Example 1, excessive electrolyte was removed through the through-hole penetrating the second electrode and thereby the polymer electrolyte was completely filled to implement complete adherence between the electrolyte and the second electrode. On the contrary, in the solar cell according to Comparative Example 8 without a through-hole, electrolyte was not completely filled to implement incomplete contacting between the electrolyte and the second electrode.

Ion conductivity (mS/cm), open voltage (V), short-circuit current (mA/cm$^2$), fill factor (%), and photovoltaic efficiency (%) of the solar cells according to Examples 1 to 3 and Comparative Examples 2 to 5 were measured. The measurement results are shown in the following Table 1.

Herein, a xenon lamp of Oriel, 01193 (available from Newport Corp., USA), was used as a light source, and the solar condition (AM 1.5) of the xenon lamp was corrected by using a standard photovoltaic cell (Frunhofer Institute Solare Engeriessysteme, Certificate No. C-ISE369, Type of material: Mono-Si + KG filter).

The fill factor is a value obtained by dividing Vmp$\times$Jmp, where Vmp is a current density and Jmp is a voltage at a maximal electric power voltage, by Voc$\times$Jsc. The photovoltaic efficiency ($\eta$) of a solar cell is a conversion efficiency of solar energy to electrical energy, which can be obtained by dividing a solar cell electrical energy (current$\times$voltage$\times$fill factor) by an energy per a unit area ($P_{inc}$) as shown the following Equation 1.

## Equation 1

$$\eta=(Voc\cdot Jsc\cdot FF)/(P_{inc})$$

wherein the $P_{inc}$ is 100mW/cm$^2$ (1sun).

Table 1

| | Weight average molecular weight of the first polymer or liquid compound (g/mol) | Particle diameter of inorganic nano-particles (nm) | Ion conductivity (mS/cm) | Open voltage (V) | Short-circuit current (mA/cm$^2$) | Fill factor (%) | Efficiency (%) |
|---|---|---|---|---|---|---|---|
| Ex.1 | 250 | 30 | 0.16 | 0.78 | 14.98 | 66.7 | 7.79 |
| Ex.2 | 500 | 30 | 0.11 | 0.74 | 14.21 | 67.5 | 7.10 |
| Ex. 3 | 88.1 | 30 | 0.21 | 0.76 | 15.32 | 65.5 | 7.81 |
| Comp. Ex. 2 | 250 | 30 | 0.11 | 0.75 | 10.24 | 69.9 | 5.36 |
| Comp. Ex. 3 | 250 | - | 0.06 | 0.71 | 9.68 | 71.2 | 4.89 |
| Comp. Ex. 4 | 750 | 30 | 0.08 | 0.65 | 13.05 | 63.2 | 5.36 |
| Comp. Ex. 5 | 1000 | 30 | 0.05 | 0.62 | 9.44 | 54.8 | 3.21 |

As shown in Table 1, the solar cells including the electrolyte according to Examples 1 to 3 show excellent cell characteristics compared those of Comparative Examples 2 to 5. The solar cells according to Comparative Examples 4 and 5 including the first polymer having a weight average molecular weight of more than 500mg/mol show lower characteristics. These results indicate that the characteristics of the first polymer have a large effect on cell characteristics.

The solar cell according to Example 1 including the polymer gel electrolyte that is composed of the first polymer, the second polymer, and the TiO$_2$ nano-particles shows high ion conductivity and short-circuit current compared to the solar cell according to Comparative Example 2 including the polymer gel electrolyte where the first polymer was gellized by addition of silica nano-particles. These results are caused by the fact that the silica nano-particles for a gelling agent lower gelation of an electrolyte due to weak particle interactions and electrolyte ion conductivity is deteriorated by gelation. The TiO$_2$ nano-particles in Example 1 have more advantages in improvement of ion conductivity and light-scattering effect than the silica nano-particles in Comparative Example 2.

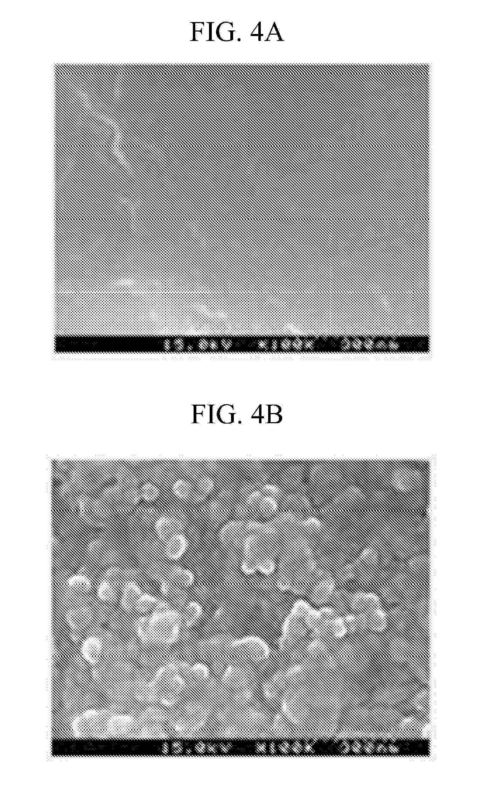

The cross-sections of the porous membranes of solar cells according to Example 1 and Comparative Example 4 were evaluated by SEM photography. The results are shown in FIGS. 4A and 4B.

FIG. 4A is a SEM photograph showing a cross-section of a porous membrane in which an electrolyte is filled in the solar cell according to Example 1. FIG. 4B is a SEM photograph showing a cross-section of a porous membrane in which an electrolyte is filled in the solar cell according to Comparative Example 4.

As shown in FIGS. 4A and 4B, as the weight average molecular weight of the first polymer becomes larger, viscosity increases. As the molecule size increases, the electrolyte incompletely invades into the nanopores of the porous membrane and electrolyte ion conductivity decreases.

In order to evaluate solar cell characteristics depending on the addition of the inorganic nano-particles and the average particle diameter of the inorganic nano-particles, open voltage (V), short-circuit current (mA/cm$^2$), fill factor (%), and efficiency (%) of the solar cells according to Examples 2 and 4 to 9 and Comparative Example 3 were measured. The results are shown in the following Table 2.

Table 2

| | Particle diameter (nm) | Open voltage (V) | Short-circuit current (mA/cm$^2$) | Fill factor (%) | Efficiency (%) |
|---|---|---|---|---|---|
| Ex.2 | 30 | 0.74 | 14.21 | 67.5 | 7.10 |
| Ex. 4 | 30 | 0.69 | 13.20 | 70.8 | 6.44 |
| Ex. 5 | 30 | 0.72 | 13.15 | 71.9 | 6.77 |
| Ex. 6 | 180 | 0.73 | 12.97 | 75.0 | 7.07 |
| Ex. 7 | 10 | 0.72 | 11.80 | 72.8 | 6.89 |

(continued)

|  | Particle diameter (nm) | Open voltage (V) | Short-circuit current (mA/cm$^2$) | Fill factor (%) | Efficiency (%) |
|---|---|---|---|---|---|
| Ex. 8 | 100 | 0.72 | 13.35 | 73.1 | 7.03 |
| Ex. 9 | 1000 | 0.75 | 8.17 | 72.0 | 4.41 |
| Comp. Ex. 3 | - | 0.71 | 9.68 | 71.2 | 4.89 |

As shown in Table 2, the solar cells according to Examples 2 and 4 to 9 including a polymer gel electrolyte in which various inorganic nano-particles are added show excellent cell efficiency compared to that of Comparative Example 3 including a polymer gel electrolyte without inorganic nano-particles.

The results also show that short-circuit currents are changed depending on the average particle size of the TiO$_2$ nano-particles. For example, the solar cell according to Example 9 including 1000nm TiO$_2$ particle shows significantly increased short-circuit current due to decreased specific surface area of the particles.

The solar cell according to Example 7 including TiO$_2$ particles having a particle diameter of less than or equal to 10nm also shows slightly decreased short-circuit current due to decrease of light-scattering effect even though short-circuit current increases due to increase of specific surface area. These results indicate that the inorganic nano-particles having an average particle diameter of less than 1$\mu$ m may preferably be used. According to one embodiment, the inorganic nano-particles may have an average particle diameter of more than or equal to 10nm and less than 1 $\mu$ m.

In order to evaluate cell characteristics depending on the amount of the inorganic nano-particles, open voltage (V), short-circuit current (mA/cm$^2$), fill factor (%), and efficiency (%) of the solar cells according to Example 10 to 16 were measured as above. The results are shown in the following Table 3.

Table 3

|  | Amount of titanium oxide nano-particles (wt%) | Open voltage(V) | Short-circuit current (mA/cm$^2$) | Fill factor (%) | Efficiency (%) |
|---|---|---|---|---|---|
| Ex. 10 | 10wt% | 0.74 | 17.28 | 69.5 | 8.8 |
| Ex. 11 | 1wt% | 0.72 | 17.97 | 66.2 | 8.6 |
| Ex. 12 | 5wt% | 0.71 | 20.62 | 65.2 | 9.5 |
| Ex. 13 | 20wt% | 0.69 | 19.84 | 66.1 | 9.0 |
| Ex. 14 | 30wt% | 0.64 | 13.62 | 61.2 | 5.3 |
| Ex. 15 | 15wt% | 0.70 | 18.11 | 69.8 | 8.9 |
| Ex. 16 | 40wt% | 0.62 | 11.94 | 60.2 | 4.5 |

As shown in Table 3, when the titanium oxide nano-particles were used in an amount of 1 to 30wt%, efficiency is more improved. When the titanium oxide nano-particles are 5wt%, efficiency is most improved. Example 16 including 40wt% of titanium oxide nano-particles shows a significant short-circuit current decrease and thereby deteriorated efficiency. These results indicate that the extra amount of the inorganic nano-particles in the electrolyte cell reduce ion amount filled in the electrolyte, and thereby oxidation-reduction reactions of the solar cell do not occur smoothly.

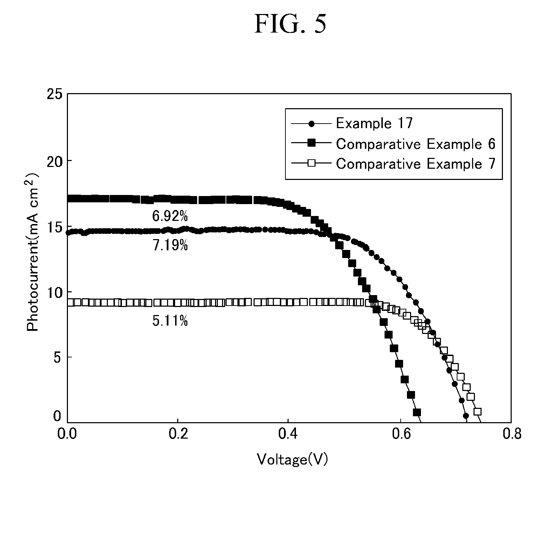

In order to evaluate photovoltaic efficiency of the solar cells according to Example 17 and Comparative Examples 6 and 7, photoelectric current-voltage was measured. From the measured photoelectric current-voltage curved line, a short-circuit current, an open voltage, a fill factor, and photovoltaic efficiency were calculated. The results are shown in FIG. 5 and the following Table 4.

Table 4

|  | Short-circuit current (mA/cm$^2$) | Open voltage (V) | Fill factor (%) | Efficiency (%) |
|---|---|---|---|---|
| Ex. 17 | 14.55 | 0.72 | 68.3 | 7.19 |
| Comp. Ex. 6 | 17.15 | 0.64 | 63.4 | 6.92 |
| Comp. Ex. 7 | 9.15 | 0.75 | 74.6 | 5.11 |

FIG. 5 shows photoelectric current-voltage characteristics of the solar cells according to Example 17 and Comparative Examples 6 and 7.

As shown in Table 4 and FIG. 5, the solar cell according to Comparative Example 7 including a polymer gel electrolyte shows significantly low current and photovoltaic efficiency. On the contrary, the solar cell according to Example 17 including a polymer gel electrolyte where titanium oxide inorganic nano-particles are further added shows a better current and more improved efficiency compared to the solar cell according to Comparative Example 6 including a liquid electrolyte.

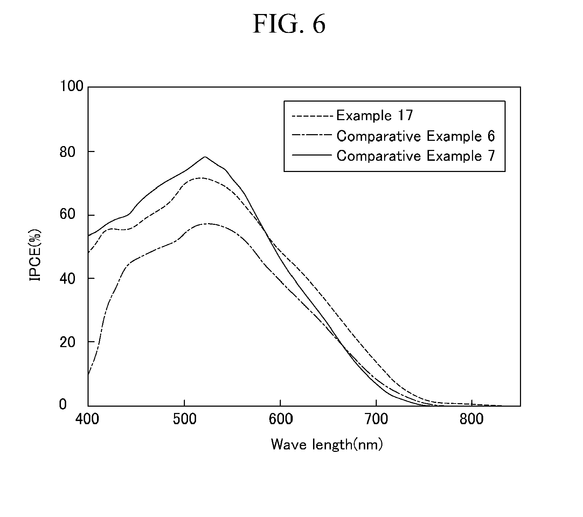

Photocharge efficiency (IPCE: incident photon-to-current efficiency) of the solar cells according to Example 17 and Comparative Examples 6 and 7 were measured. The results are shown in FIG. 6.

As shown in FIG. 6, the solar cell according to Comparative Example 7 including the polymer gel electrolyte turned out to have a low IPCE compared to the solar cell according to Comparative Example 6 including the liquid electrolyte. This result is caused by the fact that the solar cell according to Comparative Example 7 includes a polymer besides a liquid electrolyte to be gellized resulting in decrease of ion conductivity and current generation. On the contrary, the solar cell according to Example 17 including the titanium oxide inorganic nano-particles in the polymer gel electrolyte shows increase of ion conductivity due to addition of the titanium oxide and thereby increase of current generation. The titanium oxide inorganic nano-particles also increase IPCE at a long wavelength due to a light scattering effect.

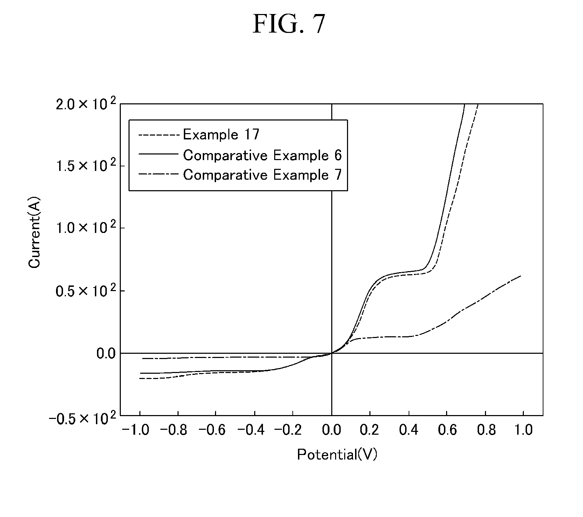

With respect to the solar cells according to Example 17 and Comparative Examples 6 and 7, current-potential was measured. From the measurement, ion diffusion coefficient ($D_{app}$) was calculated by Equation 2. The results are shown in FIG. 7.

<u>Equation 2</u>

$$Dapp = \frac{Iss}{4ncaF}$$

Wherein, in Equation 2, $I_{SS}$ is a current at a normal state, n is a number of transferred electrons per molecule, c is concentration, a is diameter of a platinum microelectrode, and F is a Faraday constant.

As shown in FIG. 7, in the case of the solar cell according to Comparative Example 7, the ion diffusion coefficient significantly decreases due to an increase of viscosity. However, in the case of the solar cell according to Example 17 including the titanium oxide inorganic nano-particles added to the electrolyte, the ion diffusion coefficient is restored to an equivalent of the liquid electrolyte according to the electrolyte according to Comparative Example 6.

Open voltage (V), short-circuit current (mA/cm$^2$), fill factor (%), and efficiency (%) of the solar cell according to Example 10 were measured according to the same method as above, and were compared to the results of the solar cell according to Comparative Example 1. The results are shown in the following Table 5.

Table 5

| Electrolyte | Open voltage (V) | Short-circuit current (mA/cm$^2$) | Fill factor (%) | Efficiency (%) |
|---|---|---|---|---|
| Comp. Ex. 1 | 0.78 | 15.28 | 66.2 | 8.2 |
| Ex. 10 | 0.74 | 17.28 | 69.5 | 8.8 |

As shown in Table 5, the solar cell according to Example 10 shows higher efficiency that that of Comparative Example 1 including the liquid electrolyte. In the case of the solar cell according to Example 10, the titanium oxide inorganic nano-particles improve electrolyte ion conductivity even though gelation is performed by addition of the polymer.

From these results, it can be seen that the inorganic nano-particles added to the polymer gel electrolyte improve cell efficiency by about 4% compared to a liquid electrolyte, and endows excellent durability.

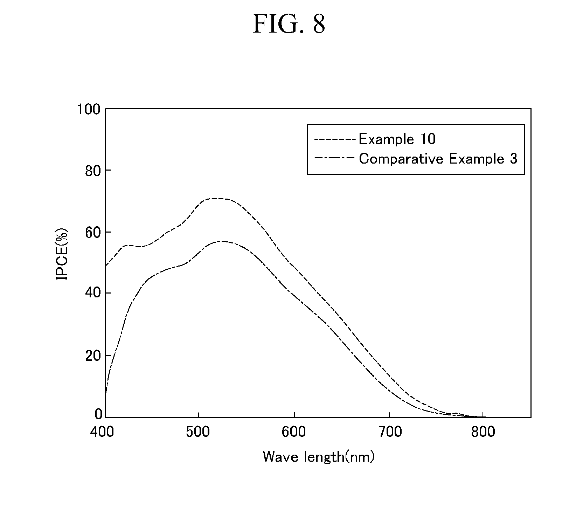

The photocharge efficiency changes (IPCE: incident photon-to-current efficiency) of the solar cells according to Example 10 and Comparative Example 3 were measured. The results are shown in FIG. 8.

As shown in FIG. 8, the solar cell according to Comparative Example 4 including the polymer gel electrolyte shows lower IPCE than that of Example 10 because of the gelation of the polymer added in the liquid electrolyte resulting in a decrease of ion conductivity and current generation. However, the titanium oxide inorganic nano-particles added in the polymer gel electrolyte of the solar cell according to Example 10 increase ion conductivity, and thereby increases current generation. The titanium oxide inorganic nano-particles also increase IPCE at a long wavelength due to a light scattering effect.

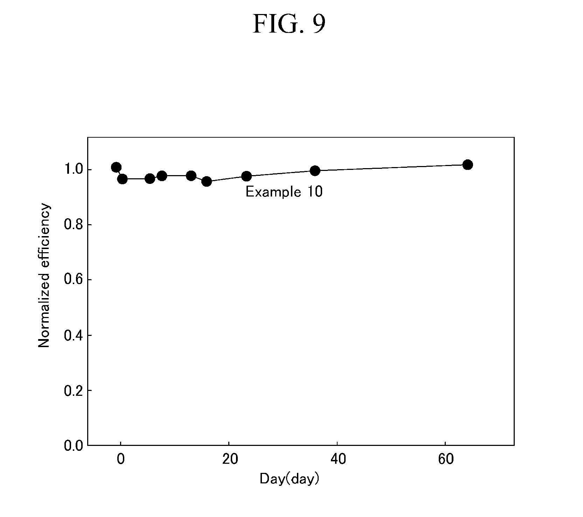

Efficiency decrease (decrement) during operations of solar cells according to Example 10 for 60 days was measured. The normalized efficiency is obtained by percentage of measured efficiency with respect to the initial efficiency by the following Equation 3. The results are shown in FIG. 9.

<u>Equation 3</u>

$$NormalizedEfficiency = \frac{MeauredEfficiency}{InitialEfficiency} \times 100$$

As shown in FIG. 9, the normalized efficiency of the solar cell including the polymer gel electrolyte according to Example 10 does not decrease.

Open voltages (V), short-circuit currents (mA/cm$^2$), fill factors (%), and efficiency (%) of the solar cells according to Examples 10 and 18 were measured according to the same method as above. The measurement results are shown in the following Table 6.

Table 6

| Electrolyte | Open voltage (V) | Short-circuit current (mA/cm$^2$) | Fill factor (%) | Efficiency (%) |
|---|---|---|---|---|
| Ex. 10 | 0.74 | 17.28 | 69.5 | 8.8 |
| Ex. 18 | 0.75 | 18.13 | 68.9 | 9.4 |

As shown in Table 6, the solar cell according to Example 18 shows higher efficiency that that of Example 10 including the gel electrolyte. In the case of the solar cell according to Example 18, polymer solutions having various viscosities are sequentially coated to improve assembling properties between the first and second electrodes. As a result, the solar cell according to Example 18 shows higher efficiency. In the foregoing discussions, those referred to as comparative examples do not necessarily represent prior art and the term "comparative example" does not constitute an admission of prior art.

The electrolyte composition for a dye sensitized solar cell according to one embodiment has improved ion conductivity and enhances cell stability and durability when it is applied to a dye sensitized solar cell.

**Claims**

1. An electrolyte composition for a dye sensitized solar cell, comprising:

    a first compound having a weight average molecular weight of less than or equal to about 500 which is a polymer or a non-volatile non-polymeric liquid compound;
    a second compound which is a polymer having a weight average molecular weight of more than or equal to about 2000; and
    inorganic nano-particles.

2. The composition of Claim 1, wherein the first compound is in an amount of 1 to 95wt% based on the total weight of the composition.

3. The composition of Claim 1, wherein the first compound is a polymer which comprises a liquid-phase polymer.

4. The composition of Claim 1, wherein the first compound is a polymer which comprises at least one selected from the group consisting of polyalkyleneoxide, polyacrylonitrile, polyalkylether, polyalkyleneimine, polyalkylenesulfide, a copolymer of two or more of the foregoing, and a mixture of two or more of the foregoing.

5. The composition of Claim 1, wherein the first compound is a non-polymeric compound which comprises one selected from the group consisting of alkylene carbonate, a room temperature molten salt, and a combination thereof.

6. The composition of Claim 5, wherein the room temperature molten salt comprises an ionic liquid compound comprising imidazolium.

**7.** The composition of Claim 1, wherein the second compound which is a polymer comprises a solid-phase polymer.

**8.** The composition of Claim 1, wherein the second compound which is a polymer comprises at least one selected from the group consisting of polyalkyleneoxide, polyacrylonitrile, polyalkyleneimine, polyalkylenesulfide, polyvinylidenehalide, a copolymer of two or more of the foregoing, and a mixture of two or more of the foregoing.

**9.** The composition of Claim 1, wherein the second compound which is a polymer is in an amount of 1 to 20wt% based on the total weight of the composition.

**10.** The composition of Claim 1, wherein the inorganic nano-particles comprise at least one selected from the group consisting of a carbon-based material, a metal oxide, and a combination thereof.

**11.** The composition of Claim 10, wherein the carbon-based material comprises at least one selected from the group consisting of graphite, denka black, ketjen black, acetylene black, carbon nanotubes, carbon nanofiber, carbon nanowire, carbon nanoballs, activated carbon, fullerene, and combinations thereof.

**12.** The composition of Claim 10, wherein the metal oxide comprises an oxide of one selected from the group consisting of Al, Si, Sn, Zr, Ti, W, Zn, In, Ba, Nb, Ta, La, Sr, Y, Ho, Bi, Ce, and combinations thereof.

**13.** The composition of Claim 1, wherein the inorganic nano-particles have an average particle diameter of less than 1 $\mu$m.

**14.** The composition of Claim 1, wherein the inorganic nano-particles are in an amount of 1 to 30wt% based on the total weight of the composition.

**15.** The composition of Claim 1, further comprising a redox derivative,
wherein the redox derivative is configured to produce an $I/I_3^-$ redox couple.

**16.** The composition of Claim 1, further comprising a volatile organic solvent selected from the group consisting of acetonitrile, alcohol, tetrahydrofuran, acetone, dimethylsulfoxide, dimethylformamide, methoxyacetonitrile, and a mixture of two or more of the foregoing.

**17.** The composition of Claim 1, wherein the composition is in a form of a gel.

**18.** A dye sensitized solar cell, comprising a composition according to any one of Claims 1 to 17.

**19.** The solar cell according to Claim 18, further comprising:

    a first electrode; and
    a second electrode substantially opposing the first electrode,

wherein at least one layer comprising the composition according to any one of Claims 1 to 17 is interposed between the first and second electrodes.

**20.** The solar cell of Claim 19, wherein at least one of the first and second electrodes is substantially transparent.

**21.** The solar cell of Claim 19, further comprising:

    a first layer interposed between the first and second electrodes, the first layer comprising the composition having a first viscosity; and
    a second layer interposed between the first layer and the second electrode, the second layer comprising the composition having a second viscosity, the second viscosity being different from the first viscosity.

**22.** The solar cell of Claim 19, wherein the composition has an increasing viscosity gradient from the first electrode toward the second electrode.

**23.** An apparatus comprising the solar cell of any one of Claims 18 to 22, wherein the apparatus is selected from the group consisting of external glass walls of a building or a glass greenhouse.

24. A method of manufacturing a dye sensitized solar cell according to any one of Claims 18 to 22 comprising the steps:

forming a light absorption layer over a first electrode, the light absorption layer comprising a porous membrane;
providing the composition of any one of Claims 1 to 17 in or on the light absorption layer, thereby forming at least one electrolyte layer; and
forming a second electrode over the electrolyte layer.

25. The method of Claim 24, wherein the formed electrolyte layer is in gel form.

26. The method of claim 24 or 25, wherein the composition further comprises a volatile organic solvent selected from the group consisting of acetonitrile, alcohol, tetrahydrofuran, acetone, dimethylsulfoxide, dimethylformamide, methoxyacetonitrile, and combinations thereof, vaporizing of the volatile organic solvent after providing the composition is included.

27. The method of Claim 24, wherein providing the composition comprises increasing the viscosity of the composition from the first electrode toward the second electrode.

28. The method of Claim 24, wherein providing the composition comprises:

providing the composition having a first viscosity; and
providing the composition having a second viscosity, the second viscosity being different from the first viscosity.

29. The method of claim 24, wherein the second electrode comprises at least two through-holes.

30. The method of claim 29, which further comprises removing extra polymer electrolyte through the through-holes after assembling the first and second electrodes and then sealing the through-holes.

**Amended claims in accordance with Rule 137(2) EPC.**

26. The method of claim 24 or 25, wherein the composition further comprises a volatile organic solvent selected from the group consisting of acetonitrile, alcohol, tetrahydrofuran, acetone, dimethylsulfoxide, dimethylformamide, methoxyacetonitrile, and combinations thereof, vaporizing of the volatile organic solvent after providing the composition is included.

27. The method of Claim 24, wherein providing the composition comprises forming an electrolyte multi-layer having a viscosity of the composition increasing from the first electrode toward the second electrode.

28. The method of Claim 24, wherein providing the composition comprises:

providing the composition having a first viscosity; and
providing the composition having a second viscosity, the second viscosity being different from the first viscosity.

29. The method of claim 24, wherein the second electrode comprises at least two through-holes.

30. The method of claim 29, which further comprises removing extra polymer electrolyte through the through-holes after assembling the first and second electrodes and then sealing the through-holes.

FIG. 1

<u>10</u>

11
12
13
14

# FIG. 2

## FIG. 3A

16

## FIG. 3B

## FIG. 4A

## FIG. 4B

# FIG. 5

# FIG. 6

FIG. 7

# FIG. 8

# FIG. 9

**European Patent Office**

**EUROPEAN SEARCH REPORT**

Application Number

EP 07 10 1383

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 505 680 A (MAX PLANCK GES ZUR FOERDERUNGD [DE]) 9 February 2005 (2005-02-09) * the whole document * ----- | 1-27,29, 30 | INV. H01G9/20 |
| X | EP 1 653 549 A (FUJIKURA LTD [JP]) 3 May 2006 (2006-05-03) * the whole document * ----- | 1-27,29, 30 | |
| A | EP 1 091 373 A1 (FUJI PHOTO FILM CO LTD [JP]) 11 April 2001 (2001-04-11) * paragraph [0064] * ----- | | |
| A | EP 0 911 841 A2 (FUJI PHOTO FILM CO LTD [JP]) 28 April 1999 (1999-04-28) * paragraph [0123] * ----- | | |
| A | EP 1 139 357 A2 (FUJI PHOTO FILM CO LTD [JP]) 4 October 2001 (2001-10-04) * the whole document * ----- | 1,5,6 | |

**TECHNICAL FIELDS SEARCHED (IPC)**

H01L
H01M

The present search report has been drawn up for all claims

| Place of search | Date of completion of the search | Examiner |
|---|---|---|
| The Hague | 29 May 2007 | Wolfbauer, Georg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 .........................................................................................................
& : member of the same patent family, corresponding document

EPO FORM 1503 03.82 (P04C01)

EP 1 923 896 A1

## ANNEX TO THE EUROPEAN SEARCH REPORT
## ON EUROPEAN PATENT APPLICATION NO.

EP 07 10 1383

This annex lists the patent family members relating to the patent documents cited in the above-mentioned European search report.
The members are as contained in the European Patent Office EDP file on
The European Patent Office is in no way liable for these particulars which are merely given for the purpose of information.

29-05-2007

| Patent document cited in search report | | Publication date | Patent family member(s) | | Publication date |
|---|---|---|---|---|---|
| EP 1505680 | A | 09-02-2005 | NONE | | |
| EP 1653549 | A | 03-05-2006 | AU | 2004256669 A1 | 20-01-2005 |
| | | | WO | 2005006482 A1 | 20-01-2005 |
| | | | KR | 20060038992 A | 04-05-2006 |
| | | | US | 2006174932 A1 | 10-08-2006 |
| EP 1091373 | A1 | 11-04-2001 | NONE | | |
| EP 0911841 | A2 | 28-04-1999 | AT | 266246 T | 15-05-2004 |
| | | | AT | 230517 T | 15-01-2003 |
| | | | DE | 69810421 D1 | 06-02-2003 |
| | | | DE | 69810421 T2 | 02-10-2003 |
| | | | DE | 69823706 D1 | 09-06-2004 |
| | | | DE | 69823706 T2 | 28-04-2005 |
| EP 1139357 | A2 | 04-10-2001 | AT | 341823 T | 15-10-2006 |
| | | | JP | 2001283943 A | 12-10-2001 |

EPO FORM P0459

For more details about this annex : see Official Journal of the European Patent Office, No. 12/82